Europäisches Patentamt

European Patent Office

Office européen des brevets

(19)

(11) Publication number: **0 437 340 A2**

# (12) EUROPEAN PATENT APPLICATION

(21) Application number: **91300117.8**

(51) Int. Cl.⁵: **H04N 5/217**

(22) Date of filing: **08.01.91**

(30) Priority: **10.01.90 JP 3241/90**

(43) Date of publication of application:
**17.07.91 Bulletin 91/29**

(84) Designated Contracting States:
**DE FR GB**

(71) Applicant: **SEIKO INSTRUMENTS INC.**
**31-1, Kameido 6-chome Koto-ku**
**Tokyo 136 (JP)**

(72) Inventor: **Machida, Satoshi, c/o SEIKO**
**INSTRUMENTS INC.**
**31-1 Kameido 6-chome**
**Koto-ku, Tokyo (JP)**
Inventor: **Kawahara, Yukito, c/o SEIKO**
**INSTRUMENTS INC.**
**31-1 Kameido 6-chome**
**Koto-ku, Tokyo (JP)**
Inventor: **Mukainakano, Hiroshi, c/o SEIKO**
**INSTRUMENTS INC.**
**31-1 Kameido 6-chome**
**Koto-ku, Tokyo (JP)**

(74) Representative: **Caro, William Egerton et al**
**J. MILLER & CO. Lincoln House 296-302 High**
**Holborn**
**London WC1V 7JH (GB)**

(54) Image sensor.

(57) An image sensor has an array of operative bipolar transistors (7) for effecting photo-electric conversion of incident light. An array of dummy bipolar transistors (11) optically shielded from the incident light are disposed adjacent and corresponding to the operative bipolar transistors (7) to constitute pairs of operative and dummy bipolar transistors. Pairs of re-set switches (8, 12) are connected to the corresponding pairs of transistors (7, 11) at their base regions to re-set concurrently each pair of the operative and dummy bipolar transistors.

EP 0 437 340 A2

FIG. 1

# IMAGE SENSOR

This invention relates to image sensors, for example, for use in facsimile machines. Such image sensors are sometimes referred to as image scanners and convert an optical signal into an electrical signal.

A conventional image sensor is such that photo-carriers are stored in a base of a bipolar transistor and an electric signal is taken from an emitter thereof. Figure 5 shows one example of such a conventional image sensor. A bipolar transistor 1 of NPN type has a collector 2 held at a constant potential $V_{CC}$. An emitter 3 of the bipolar transistor 1 is connected to a common signal line 5 to a pixel selecting switch 4. A base of the bipolar transistor 1 is held floating. The pixel selecting switches 4 are successively turned ON to read out photo-carriers stored in the respective bipolar transistors. During the reading operation, the bipolar transistor can output electric charge several tens to hundreds of times as great as the stored photo-carriers according to the amplification factor of the transistor.

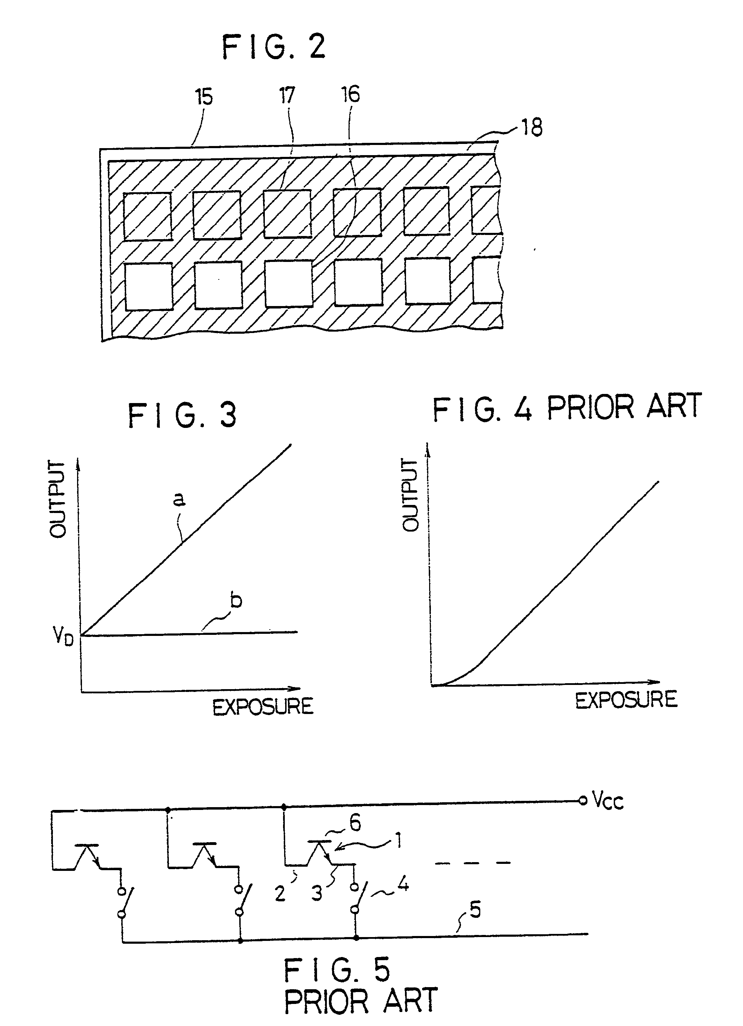

In this type of conventional image sensor, since the base 6 of the bipolar transistor 1 is held floating, some electric charge remains in the base after the previous output operation, thereby affecting the next output operation. This generates a storage image phenomenon. Further, since an emitter junction must be forward-biased to effect transistor operation, some of the photo-carriers are used for forward-biasing of the emitter junction. Therefore, as shown in Figure 4, the output power cannot increase linearly in low light conditions.

The present invention seeks to provide an image sensor which exhibits little or no storage image phenomenon and has improved output characteristics.

According to the present invention there is provided an image sensor having an array of operative bipolar transistors for effecting photo-electric conversion of incident light and characterised by an array of dummy bipolar transistors optically shielded from the incident light and disposed adjacent and corresponding to the operative bipolar transistors to constitute pairs of operative and dummy bipolar transistors ; and pairs of re-set switches connected to the corresponding pairs of transistors at their base regions to re-set concurrently each pair of the operative and dummy bipolar transistors.

In the above constructed image sensor, after output operation of each pixel, the corresponding pair of re-set switches connected to the corresponding pair of bipolar transistors in the parallel arrays are operated to re-set the corresponding bases to a constant potential thereby to initialise the bipolar transistor pair in a given state. Accordingly, such a construction can effectively avoid storage image phenomenon which would be caused by remaining electric charge in the base region. Further, the re-set potential of the base is set to a relatively high level so as to charge into the base some of the initial electric charge sufficient to forward-bias the emitter junction. By such an operation, the output power is made proportional to incident light intensity in relatively low light conditions.

The image sensor may include pairs of selecting switches connected to the emitters of the corresponding pairs of transistors so that an image signal and an off set signal are fed to common signal lines.

The transistors may be NPN transistors.

The invention is illustrated, merely by way of example, in the accompanying drawings, in which :-

Figure 1 is a circuit diagram of an embodiment of an image sensor according to the present invention ;

Figure 2 is an illustrative diagram showing arrangement of base regions and a shielding film of the image sensor of Figure 1 ;

Figure 3 is a graph showing photo-electric conversion characteristics of an image sensor according to the present invention ;

Figure 4 is a graph showing photo-electric conversion characteristics of a conventional image sensor ; and

Figure 5 is a structural diagram of a conventional image sensor.

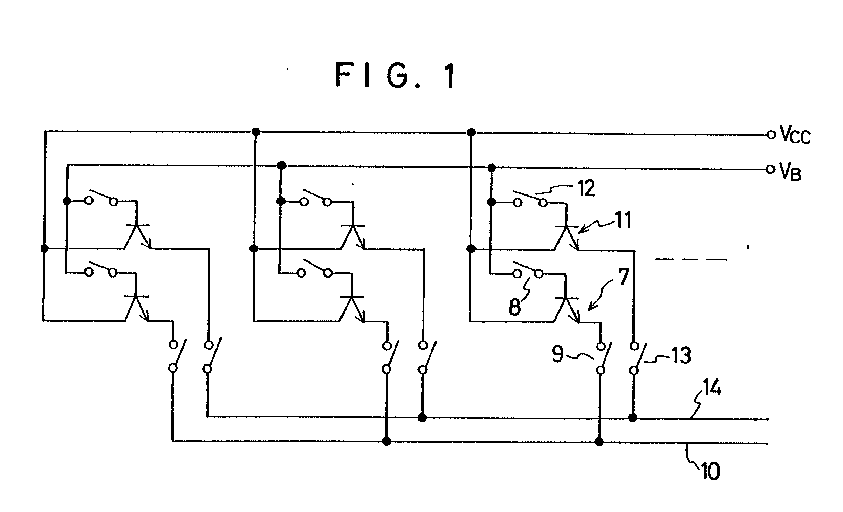

Referring to Figure 1, an image sensor according to the present invention is comprised of a main array composed of bipolar transistors 7, each having a collector held at a constant potential $V_{CC}$. A base region of each bipolar transistor 7 is opened or exposed such that photo-carriers induced by incident light are stored in the base. This base is connected via a respective re-set switch 8 to a base re-set potential $V_B$ through the re-set switch 8. An emitter of each bipolar transistor 7 is connected to a common image signal light 10 through a pixel selecting switch 9. A plurality of the bipolar transistors 7 are linearly arranged in an array.

A plurality of dummy bipolar transistors 11 are also linearly arranged in an array corresponding to the operative bipolar transistors 7. The dummy bipolar transistors 11 have the same arrangement as that of the operative bipolar transistors 7, but are masked or covered over their base region by a shielding film of, for example, aluminium etc. Each dummy bipolar transistor 11 has a collector connected to the potential $V_{CC}$, a base receptive of the re-set potential $V_B$ through a re-set switch 12 and an emitter connected to a common off set signal line 14 through a pixel selecting switch 13.

Figure 2 shows the arrangement of the base regions and the shielding film in the image sensor of Figure 1. A semi-conductor chip 15 is formed linearly with exposed base regions 16 which define a receiving region of incident light. Masked base regions 17 of the dummy bipolar transistors are disposed adjacent in parallel to the exposed base regions 16. The base regions 17 of the dummy bipolar transistors are covered by an aluminium light shielding film 18 which is selectively removed from the base region 16 of the operative bipolar transistors.

The operation of the image sensor of Figure 1 will now be described. The pair of pixel selecting switches 9, 13 connected to the corresponding pair of operative and dummy bipolar transistors 7, 11 are concurrently turned ON to enable the pair of transistors 7, 11 to output electric charge to the common signal lines 10, 14, respectively. The pairs of pixel selecting switches 9, 13 are successively turned ON so that an image signal and an off set signal are fed to the common signal lines 10, 14, respectively, on a time sequential basis. After the outputting or reading operation, the emitters of the pair of bipolar transistors 7, 11 are held to a constant potential through the pixel selecting switches 9, 13, respectively. However, some electric charge remains in their bases.

Then, the pair of base re-set switches 8, 12 are turned ON so that the base potential of the pair of bipolar transistors 7, 11 are set to the potential $V_B$. Thereafter, the pair of base re-set switches 8, 12 and the pair of pixel selecting switches 9, 13 are turned OFF so that the operative bipolar transistor 7 is initialised to effect a new storing operation of photo-carriers in its base region in response to incident light. Since the base of the dummy bipolar transistor 11 is optically shielded, no photo-carriers are stored so that the dummy bipolar transistor 11 continuously provides an off set signal having a level identical to that of a dark image signal of the operative bipolar transistor 7. Since the potential $V_B$ is set to a relatively high level effective to sufficiently forward-bias the emitter junctions when the pixel selecting switches 9, 13 are turned ON, the output of the bipolar transistor 7 has a good linearity in low light conditions. The bases of the pair of bipolar transistors 7, 11 are re-set to the potential $V_B$ each reading operation, hence the influence of previous operation is completely removed thereby to avoid the storage image phenomenon.

Figure 3 shows the photo-electric conversion characteristics of an image sensor according to the present invention. The line $\underline{a}$ indicates the photo-electric conversion characteristics of the operative bipolar transistor 7, and the line $\underline{b}$ indicates the photo-electric conversion characteristics of the dummy bipolar transistor 11. An off set potential $V_D$ of the dark image signal may vary dependent on the position of pixels : however the pair of bipolar transistors 7, 11 are closely disposed to each other such that the off set potential $V_D$ does not differ between them. Accordingly, the common image signal line 10 and the common off set signal line 14 can be connected to a differential amplifier (not shown), which can provide an output signal proportional to the incident light intensity and which can suppress variation of the dark image output.

The operation timing of each pixel selecting switch can be controlled by a scanning circuit, which may be integrated into the same semi-conductor chip. The differential amplifier may also be integrated into the same semi-conductor chip.

The image sensor of Figure 1 has a simple structure and is effective to suppress variation in the dark image output, thus ensuring good linearity of the output signal and eliminating the image storage phenomenon.

## Claims

1. An image sensor having an array of operative bipolar transistors (7) for effecting photo-electric conversion of incident light and characterised by an array of dummy bipolar transistors (11) optically shielded from the incident light and disposed adjacent and corresponding to the operative bipolar transistors (7) to constitute pairs of operative and dummy bipolar transistors ; and pairs of re-set switches (8, 12) connected to the corresponding pairs of transistors (7, 11) at their base regions to re-set concurrently each pair of the operative and dummy bipolar transistors.

2. An image sensor as claimed in claim 1 characterised by pairs of selecting switches (9, 13) connected to the emitters of the corresponding pairs of transistors (7, 11) so that an image signal and an off set signal are fed to common signal lines (10, 14).

3. An image sensor as claimed in claim 1 or 2 characterised in that the transistors are NPN transistors.

F I G. 1

EP 0 437 340 A2

# FIG. 2

# FIG. 3

# FIG. 4 PRIOR ART

# FIG. 5
# PRIOR ART